# EUROPÄISCHE PATENTSCHRIFT

(11) **EP 1 284 096 B1**
(45) Veröffentlichungstag und Bekanntmachung des Hinweises auf die Patenterteilung: **06.10.2004**
(21) Anmeldenummer: 01943146.9
(22) Anmeldetag: 23.05.2001
(51) Int. Cl.: H05K 13/04

(54) **VORRICHTUNG ZUM BESTÜCKEN VON SUBSTRATEN MIT ELEKTRISCHEN BAUTEILEN**
DEVICE FOR FITTING SUBSTRATES WITH ELECTRIC COMPONENTS
DISPOSITIF POUR IMPLANTER DES COMPOSANTS ELECTRIQUES SUR DES SUBSTRATS

(30) Priorität: 23.05.2000 DE 10025441
(43) Veröffentlichungstag der Anmeldung: 19.02.2003
(73) Patentinhaber: SIEMENS AKTIENGESELLSCHAFT, 80333 München (DE)
(72) Erfinder: AIGNER, Sebastian, 82393 Iffeldorf (DE); MEHDIANPOUR, Mohammad, 81829 München (DE)
(86) Internationale Anmeldenummer: PCT/DE2001/001982
(87) Internationale Veröffentlichungsnummer: WO 2001/091533

(56) Entgegenhaltungen:
- US-A- 5 203 061
- US-A- 5 880 849

## Beschreibung

Die Erfindung bezieht sich auf eine Vorrichtung zum Bestücken von Substraten mit elektrischen Bauteilen mittels zumindest eines Bestückkopfes zum Handhaben der Bauteile.

Eine derartige Vorrichtung ist zum Beispiel durch die WO 98/37744 A1 bekannt geworden. Danach ist der Bestückkopf mittels einer X-Y-Positioniereinrichtung in einer Arbeitsebene verfahrbar. Die Positioniereinrichtung besteht aus einer stationären Längsführung und einem darauf verschiebbar gelagerten, querstehenden Positionierarm, entlang dem der Bestückkopf verschiebbar gelagert ist. Die stationäre Längsführung ist an einem balkenartigen Träger ausgebildet, der sich entlang einer Seite der Arbeitsebene erstreckt. Durch die Vorrichtung hindurch ist eine Förderstrecke für die Substrate hindurchgeführt. Die Förderstrecke dient in einem Teilbereich als Bestückplatz, in dem die Substrate zur Bestückung fixiert werden. Der Verfahrbereich überdeckt das Bestückfeld und die Abholstellen für die Bauteile, die mittels des Bestückkopfes aus Zuführeinrichtungen entnommen und auf das Substrat aufgesetzt werden. Insbesondere beim Aufsetzen der Bauteile müssen sehr hohe Anforderungen an die Genauigkeit erfüllt werden.

Es ist üblich, die Bestückvorrichtungen beim Hersteller komplett fertigzustellen und zu testen. Diese Tests beinhalten unter anderem eine Kalibrierung mit der Ermittlung der Offset-Werte bei der Positionierung des Bestückkopfes in den verschiedenen Teilbereichen des Bestückfeldes. Diese Offset-Werte werden in den Steuereinrichtungen der Bestückvorrichtung abgespeichert und bei jedem späteren Bestückvorgang mit einem entsprechenden Korrekturschritt berücksichtigt. Die Steuereinrichtungen sind üblicherweise in einem Chassis der Bestückvorrichtung gehalten und über Kabel mit der Positioniereinrichtung verbunden. Bei einem Austausch der Positioniereinrichtung oder auch nur Teilen davon muß die Maschine völlig neu vermessen werden, um die entsprechenden Offset-Werte neu zu bestimmen. Eine derartige Neukalibrierung der Vorrichtung am Einsatzort vorzunehmen kann mit Problemen verbunden sind, wenn dort die entsprechenden Meßeinrichtungen fehlen.

Durch die DE 36 30 178 A1 ist eine Bestückvorrichtung bekannt, bei der Funktionseinheiten baukastenartig zu einer Montageeinrichtung zusammengefügt werden, wobei die Funktionseinheiten eigene Chassis aufweisen, die mittels Verbindungselementen flanschartig miteinander verspannt werden. So wird z.B. eine Montagestation mit einem eigenen Ständer und einem X-Y-Positioniersystem an eine Transportstation angekoppelt, wobei die Montagestation mit einer eigenen Steuerelektronik versehen ist. Die modernen Bestücktechnik mit höchsten Stückleistungen und höchsten Genauigkeitsanforderungen setzt eine besonders formsteife und schwingungsarme Tragkonstruktion voraus, die mit den einzelnen am Boden aufgestellten Modulen nicht erreicht werden kann, deren Schwingungsverhalten zudem undefiniert bleibt.

Der Erfindung liegt die Aufgabe zugrunde, den Herstellungs-, Test- und Kalibrieraufwand zu verringern.

Diese Aufgabe wird durch die Erfindung gemäß Anspruch 1 gelöst. Durch die Trennung des Chassis in einen einfachen Stützkörper und den selbsttragenden Träger für die Positioniereinrichtung ist es möglich, den Träger getrennt vom Chassis herzustellen, zu testen und zu liefern. Der Träger stellt hier den eigentlichen Roboter dar, der für sich voll funktionsfähig ist. Dadurch ist es möglich, zum Beispiel im Falle einer Beschädigung der Positioniereinrichtung diese kurzfristig mit dem Träger zu entfernen und durch eine neue vollfunktionsfähige, kalibrierte und getestete Funktionseinheit zu ersetzen.

Durch die konsequente Trennung von Stützkörper und Funktionseinheit ist es möglich, sämtliche Funktionseinheiten in einer Testvorrichtung zu testen und kalibrieren, ohne daß es dazu erforderlich ist, den Stützkörper in diese Räume zu transportieren, wodurch sich der gesamte Ablauf vereinfacht. Die definierten Stützstellen des Chassis sind in der Testvorrichtung nachgebildet, so daß die Testergebnisse ohne weiteres auf die Bestückvorrichtung übertragen werden können. Durch die Zuordnung des Datenträgers zur Funktionseinheit ist sichergestellt, daß die Kenndaten nicht mit denen anderer Funktionseinheiten verwechselt werden können.

Es ist auch möglich, den Stützkörper und die Funktionseinheit getrennt zu transportieren. Das Chassis kann zum Beispiel vorab auf dem Land- oder Seeweg zum Einsatzort transportiert werden, dort aufgestellt und verankert werden. Die teure Funktionseinheit mit dem Träger und der Positioniereinrichtung und dem Bestückkopf ist so leicht, daß sie zum Beispiel per Flugzeug kurzfristig nachgeliefert und eingebaut werden kann.

Vorteilhafte Weiterbildungen der Erfindung sind in den Unteransprüchen gekennzeichnet:

Durch die Liefereinheit nach Anspruch 2 wird eine vollständige Integration der einzelnen Komponenten sichergestellt, was insbesondere durch die feste Zuordnung des Datenträgers zur Steuereinheit nach Anspruch 3 gegeben ist.

Durch die Weiterbildung nach Anspruch 4 wird die Funktionseinheit zu einem vollkommen autonomen Modul, an das lediglich noch die Versorgungsleitungen angeschlossen werden müssen.

Durch die Weiterbildung nach Anspruch 5 ist es möglich, unterschiedliche Bestückköpfe auf dem Positionierarm zu lagern, ohne daß die Positioniereinheit nachkalibriert werden muß.

Der plattenartige Träger nach Anspruch 6 stellt eine großflächige Montageplattform für die Positioniereinrichtung dar. Durch die flächenhafte Ausdehnung und durch die Abstützung werden durch die Verfahrbewegung des Bestückkopfes verursachte Schwingungen gering gehalten. Durch die Anordnung oberhalb des Bestückplatzes ergeben sich ferner kurze, biegesteife Hebelarme. Die plattenförmige Ausbildung des Trägers nach Anspruch 7 und 8 ermöglicht die Anordnung von einer oder mehreren Positioniereinrichtungen in unterschiedlicher Konfiguration, so daß die Funktionseinheit optimal an den jeweiligen Einsatzzweck angepaßt werden kann.

Nach Anspruch 9 ist es aber auch möglich, in den Stützkörper unterschiedliche Funktionseinheiten mit unterschiedlichen Positioniereinrichtungen und daran angepaßten unterschiedlichen Trägern einzusetzen.

Die Weiterbildungen nach den Ansprüchen 10 und 11 ermöglichen bei kurzen Verschiebewegen des Bestückkopfes eine hohe Positioniergenauigkeit und kurze Verfahrwege.

Die Anordnung nach Anspruch 12 ermöglicht es, mit einer Positioniereinrichtung auf beiden Zuführseiten zuzugreifen. Die Mitte der Führungen liegt dabei über dem Bestückplatz, wodurch sich die Bestückgenauigkeit erhöht. Es ist möglich, in der Förderstrecke zwei Bestückplätze mit je einer Positioniereinrichtung vorzusehen. Dementsprechend sind zu beiden Seiten beider Bestückplätze Zuführeinrichtungen für die Bauteile angeordnet, so daß sich die Vielfalt der bereitgestellten Bauteile entsprechend erhöht.

Durch die Weiterbildung nach Anspruch 13 kann die Bestückleistung erhöht werden, indem die beiden Bestückköpfe abwechselnd Bauteile an den Abholstellen aufnehmen bzw. auf das Substrat aufsetzen. Auch hier kann ein zusätzlicher Bestückplatz mit zusätzlichen Bauteilen vorgesehen werden.

Durch die Weiterbildung nach Anspruch 14 wird für den Träger eine Auflageebene geschaffen, die in einer Einstellung zum Beispiel einer Fräseinrichtung am Stützkörper bzw. am Träger bearbeitet werden kann. Eine genaue Zuordnung zwischen der Positioniereinrichtung und dem Substrat wird im Einsatz dadurch erreicht, daß mittels einer am Bestückkopf angebrachten Kamera die Lage von Zentriermarken auf dem Substrat vermessen wird und bei der Bestückung entsprechend berücksichtigt wird. Die Zuführeinrichtungen für die Bauteile haben ebenfalls Zentriermarken, die in ähnlicher Weise vermessen werden. Dadurch bedarf es nach dem Einbau des Trägers in den Stützkörper keiner weiteren Zentriermaßnahmen.

Im folgenden wird die Erfindung anhand von in der Zeichnung dargestellten Ausführungsbeispielen näher erläutert.
Figur 1 zeigt in einer schematisierten perspektivischen Ansicht eine Vorrichtung zum Bestücken von Substraten mit elektrischen Bauteilen,
Figur 2 einen Teilschnitt durch die Vorrichtung nach Figur 1.
Figur 3 eine Draufsicht auf die Teile nach Figur 2,
Figur 4 einen Teilschnitt durch eine modifizierte Vorrichtung nach Figur 1
Figur 5 eine Draufsicht auf die Teile nach Figur 4,

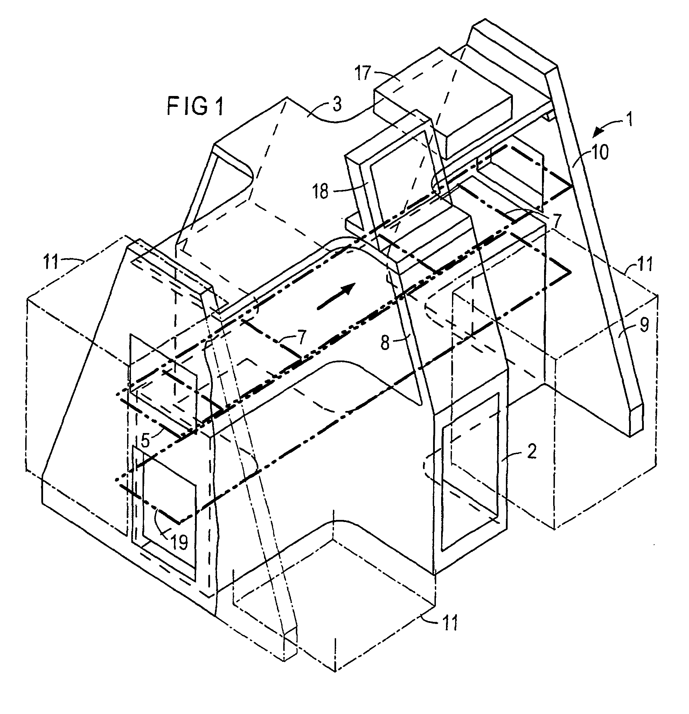

Nach den Figuren 1, 2 und 3 besteht ein Chassis 1 einer Vorrichtung zum Bestücken von Substraten 6 mit elektrischen Bauteilen 15 aus einem gegossenen Stützkörper 2 und einem daran befestigten plattenartigen Träger 3, an dem eine X-Y-Positioniereinrichtung 4 gelagert ist. Über dem Stützkörper 2 ist durch die Vorrichtung eine Förderstrecke 5 für die Substrate 6 hindurchgeführt, die in Bestückplätzen 7 der Förderstrecke 5 mit den Bauteilen bestückbar sind.

Der Stützkörper 2 weist in der Draufsicht eine kreuzförmige Struktur auf, bei der sich ein Hauptschenkel parallel zur Förderstrecke 5 und unterhalb von dieser erstreckt. Ein Mittelschenkel erstreckt sich quer zur Transportrichtung im Mittelbereich des Hauptschenkels. An seinen Enden sind wandartige, nach oben ragende Mittelstützen 8 für den Träger 3 angegossen. An den Enden der Hauptschenkel sind einstückig angesetzte Stirnwände 9 vorgesehen, die oberhalb des Stützkörpers 2 zu Endstützen 10 für den Träger 3 erweitert sind. In den Eckbereichen zwischen den Schenkeln des Stützkörpers 2 sind Stellplätze für Zuführeinrichtungen 11 für die zu bestückenden Bauteile angeordnet. Die Oberseiten der Zuführeinrichtungen 11 befinden sich im gleichen Höhenniveau wie das Substrat 6.

Der plattenartige Träger 3 ist mit Abstand oberhalb der Förderstrecke 5 angeordnet. Auf seiner Unterseite ist die Positioniereinrichtung 4 gelagert, die aus einer auf der Unterseite des Trägers 3 befestigten, sich in der Förderrichtung erstreckenden Längsführung 12 und einem dazu querstehenden Positionierarm 13 besteht, der in der Längsführung 12 verschiebbar gelagert ist. Diese ist z.B. mit Magnetteilen versehen, die zusammen mit einem Spulenteil des Positionierarms 13 einen Linearmotor bilden, der den Positionierarm antreibt.

Auf der Unterseite des Positionierarms 13 ist ein revolverartiger Bestückkopf 14 verschiebbar gelagert, mit dessen Hilfe die Bauteile 15 von Abholplätzen 16 der Zuführeinrichtungen 11 zu ihren Aufsetzstellen auf dem Substrat transportiert werden können. Die Mittelstützen 8 sind in der Förderrichtung so breit und biegesteif, daß sie durch die Bewegung des Positionierarms hervorgerufene Schwingungen wirksam verhindern. In der Querrichtung durch die Bewegung des Bestückkopfes ausgelöste Impulse werden durch die stirnseitigen Endstützen wirksam verhindert. Um eine möglichst große Bestückleistung zu erreichen, ist es zweckmäßig, für jeden Bestückplatz eine eigene Positioniereinrichtung 4 zuzuordnen.

Auf der Oberseite des Trägers 3 sind Stellplätze für Hilfseinrichtungen, zum Beispiel in Form eines Steuergeräts 17 und eines Displays 18 vorgesehen. Der Stützkörper 2 ist als gegossener Hohlkörper ausgebildet, durch dessen Hauptschenkel eine zusätzliche Transportstrecke 19 für die Substrate 6 hindurchgeführt ist. Diese Förderstrecke dient zum Beispiel dazu, Substrate an den Bestückplätzen vorbeizuschleusen. Die Hohlräume in den mittleren Nebenschenkeln können zum Beispiel dazu dienen, Stromversorgungsaggregate, pneumatische Einrichtungen oder weitere Steuergeräte aufzunehmen.

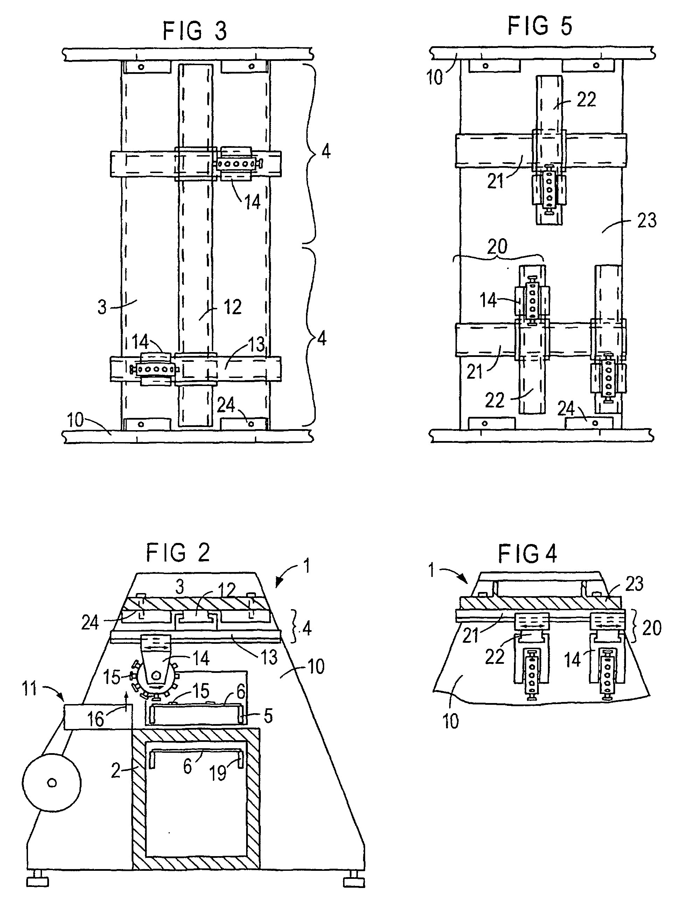

Die Vorrichtung nach den Figur 4 und 5 unterscheidet sich von der nach den Figuren 2 und 3 durch die Anordnung der Positionierachsen. Die abgewandelten Längsführungen 21 erstrecken sich hier quer zu Förderrichtung der Substrate über jedem der Bestückplätze und sind an einem abgewandelten, durch Rippen verstärkten Träger 23 befestigt. Auf der Längsführung 21 sind zwei modifizierte Positionierarme 22 mit je einem der Bestückköpfe 14 verfahrbar. Diese bilden zwei Positioniereinrichtungen 20, die wechselweise Bauteile abholen bzw. auf das Substrat aufsetzen können, wodurch sich die Bestückleistung erheblich erhöht. Die Stirnwände 10 sind mit in einer Ebene liegenden Stützstellen 24 zur definierten Auflage des Trägers 23 versehen.

## Patentansprüche

1. Vorrichtung zum Bestücken von Substraten (6) mit elektrischen Bauteilen (15) mittels zumindest eines Bestückkopfes (14) zum Handhaben der Bauteile (15),
wobei der Bestückkopf (14) mittels zumindest einer Positioniereinrichtung (4,20) in zwei Koordinatenrichtungen verfahrbar ist,
wobei stationäre Teile der Positioniereinrichtung (4,20) an einem Chassis (1) der Vorrichtung verankert sind,
**dadurch gekennzeichnet, daß** das Chassis (1) aus einem im wesentlichen passiven Stützkörper (2) und zumindest einem daran lösbar befestigten selbsttragenden Träger (3,23) besteht, an dem die stationären Teile der Positioniereinrichtung (4,20) befestigt sind,
daß der Stützkörper definierte Stützstellen (24) für den Träger (3,23) aufweist
daß der formsteife Träger (3,23) mit der Positioniereinrichtung (4,20) als derart autonome Funktionseinheit ausgebildet ist
daß sie zur Erstellung eines Datenträgers mit den Kenndaten der Funktionseinheit außerhalb des Stützkörpers (2) in einer Hilfseinrichtung testbar ist.

2. Vorrichtung nach Anspruch 1,
**dadurch gekennzeichnet,**
**daß** der Datenträger und die Funktionseinheit in einer gemeinsamen Liefereinheit zusammenfaßbar sind.

3. Vorrichtung nach Anspruch 2,
**dadurch gekennzeichnet, daß** der Datenträger Teil einer Steuereinrichtung (17) für die Positioniereinrichtung (4,20) ist.

4. Vorrichtung nach Anspruch 3,
**dadurch gekennzeichnet, daß** die Steuereinrichtung (17) am Träger (3) befestigbar und zusammen mit diesem und mit der Positioniereinrichtung (4) eine komplette Montageeinheit bildet.

5. Vorrichtung nach einem der vorhergehenden Ansprüche,
**dadurch gekennzeichnet, daß** an die Positioniereinrichtung (4,20) unterschiedliche Bestückköpfe ansetzbar sind und
daß die Bestückköpfe mit einem Speicher für kopfspezifische Kenndaten versehen sind.

6. Vorrichtung nach einem der vorhergehenden Ansprüche,
**dadurch gekennzeichnet, daß** der plattenartige Träger oberhalb zumindest eines Bestückplatzes (7) für die Substrate (6) angeordnet ist und
daß der Stützkörper (2) seitlich des Verfahrbereichs der Positioniereinrichtung mit nach oben ragenden Stützen (8,10) für den Träger (3,23) versehen ist und
daß die Positioniereinrichtung (4,20) auf der Unterseite des Trägers (3,23) angeordnet ist.

7. Vorrichtung nach einem der vorhergehenden Ansprüche,
**dadurch gekennzeichnet, daß** am Träger (3,20) unterschiedliche Positioniereinrichtungen (4,20) befestigbar sind.

8. Vorrichtung nach Anspruch 7,
**dadurch gekennzeichnet, daß** die Positioniereinrichtungen (4,20) in unterschiedlicher Konfiguration am Träger (3,23) befestigbar sind.

9. Vorrichtung nach einem der vorhergehenden Ansprüche,
**dadurch gekennzeichnet, daß** für unterschiedliche Positioniereinrichtungen (4,20) unterschiedliche Träger (3,23) am Stützkörper (2) befestigbar sind.

10. Vorrichtung nach Anspruch 9,
**dadurch gekennzeichnet, daß** die Positioniereinrichtung (4,20) eine am Träger (3,23) befestigte Längsführung (12,21) und zumindest einen an dieser verschiebbar gelagerten, querstehenden Positionierarm (13,22) aufweist, an dem der Bestückkopf (14) verschiebbar gelagert ist.

11. Vorrichtung nach Anspruch 10,
**dadurch gekennzeichnet, daß** der Bestückplatz (7) in einer Förderstrecke (5) für die Substrate (6) liegt und daß seitlich der Transportstrecke Stellplätze für Zuführeinrichtungen (11) für die Bauteile (15) vorgesehen sind.

12. Vorrichtung n ach Anspruch 10 oder 11,
**dadurch gekennzeichnet, daß** sich die Längsführung (12) mittig über der Förderstrecke (5) parallel zu dieser erstreckt und
daß der Positionierarm (13) nach beiden Seiten bis über Abholplätze (16) der beiden Zuführeinrichtungen (11) ragt.

13. Vorrichtung nach Anspruch 11,
**dadurch gekennzeichnet, daß** sich die Längsführung (21) über den Bestückplatz (7) quer zur Förderstrecke (5) erstreckt und
daß auf der Längsführung (21) zwei der voneinander unabhängig verfahrbaren Positionierarme (22) verfahrbar sind.

14. Vorrichtung nach einem der vorhergehenden Ansprüche,
**dadurch gekennzeichnet, daß** die Stützstellen (24) für die Abstützung des Trägers (3,23) am Stützkörper (2) durch waagerechte Auflageflächen gebildet sind, die sämtlich in einer Ebene liegen.

## Claims

1. Device for fitting substrates (6) with electric components (15) by means of at least one fitting head (14) for handling the components (15),
it being possible for the fitting head (14) to be moved in two coordinate directions by means of at least one positioning device (4, 20),
stationary parts of the positioning device (4, 20) being anchored to a chassis (1) of the device,
**characterized**
**in that** the chassis (1) comprises a substantially passive supporting body (2) and at least one self-supporting carrier (3, 23) which is detachably fixed thereto and to which the stationary parts of the positioning device (4, 20) are fixed,
**in that** the supporting body has defined supporting points (24) for the carrier (3, 23)
**in that** the dimensionally rigid carrier (3, 23) with the positioning device (4, 20) is designed as a functional unit, with sufficient autonomy to enable it to be tested outside the supporting body (2) in an auxiliary device in order to create a data carrier with the characteristic data of the functional unit.

2. Device according to Claim 1, **characterized in that** the data carrier and the functional unit can be combined into a common delivery unit.

3. Device according to Claim 2, **characterized in that** the data carrier is part of a control device (17) for the positioning device (4, 20).

4. Device according to Claim 3, **characterized in that** the control device (17) can be fixed to the carrier (3) and, together with the latter and with the positioning device (4), forms a complete mounting unit.

5. Device according to one of the preceding claims, **characterized in that** different fitting heads can be attached to the positioning device (4, 20), and **in that** the fitting heads are provided with a memory for head-specific characteristic data.

6. Device according to one of the preceding claims, **characterized in that** the plate-like carrier is arranged above at least one fitting station (7) for the substrates (6), and
**in that** the supporting body (2) is provided, at the side of the travel area of the positioning device, with upwardly projecting supports (8, 10) for the carrier (3, 23), and
**in that** the positioning device (4, 20) is arranged on the underside of the carrier (3, 23).

7. Device according to one of the preceding claims, **characterized in that** different positioning devices (4, 20) can be fixed to the carrier (3, 20).

8. Device according to Claim 7, **characterized in that** the positioning devices (4, 20) can be fixed to the carrier (3, 23) in a different configuration.

9. Device according to one of the preceding claims, **characterized in that** for different positioning devices (4, 20), different carriers (3, 23) can be fixed to the supporting body (2).

10. Device according to Claim 9, **characterized in that** the positioning device (4, 20) has a longitudinal guide (12, 21) fixed to the carrier (3, 23) and at least one transverse positioning arm (13, 22) displaceably mounted on the latter and on which the fitting head (14) is displaceably mounted.

11. Device according to Claim 10, **characterized in that** the fitting station (7) lies in a conveying path (5) for the substrates (6), and **in that** at the side of the transport path, spaces for feed devices (11) for the components (15) are provided.

12. Device according to Claim 10 or 11, **characterized in that** the longitudinal guide (12) extends centrally over the conveying path (5), parallel to the latter, and
**in that** the positioning arm (13) projects on both sides until beyond collecting spaces (16) of the two feed devices (11).

13. Device according to Claim 11, **characterized in that** the longitudinal guide (21) extends over the fitting station (7) and transversely with respect to the conveying path (5), and
**in that** two positioning arms (22) which can be moved independently of each other can be moved on the longitudinal guide (21).

14. Device according to one of the preceding claims, **characterized in that** the supporting points (24) for supporting the carrier (3, 23) on the supporting body (2) are formed by horizontal supporting surfaces, which all lie in one plane.

## Revendications

1. Dispositif pour l'équipement de substrats (6) avec des composants électriques (15) au moyen d'au moins une tête d'équipement (14) servant à manipuler les composants (15), la tête d'équipement (14) pouvant être déplacée dans deux directions de coordonnées au moyen d'au moins un dispositif de positionnement (4, 20), les parties fixes du dispositif de positionnement (4, 20) étant ancrées sur un châssis (1) du dispositif, **caractérisé en ce que** le châssis (1) est formé d'un corps d'appui (2) essentiellement passif et d'au moins un support (3, 23) autoportant fixé sur ce dernier de manière amovible et sur lequel les parties fixes du dispositif de positionnement (4, 20) sont fixées, **en ce que** le corps d'appui est pourvu de points d'appui définis (24) pour le support (3, 23), **en ce que** le support (3, 23) indéformable avec le dispositif de positionnement (4, 20) est exécuté en tant qu'unité fonctionnelle autonome d'une manière permettant de la tester à l'extérieur du corps d'appui (2) dans un dispositif auxiliaire afin de constituer un support de donnée comportant les données caractéristiques de l'unité fonctionnelle.

2. Dispositif selon la revendication 1, **caractérisé en ce que** le support de données et l'unité fonctionnelle peuvent être réunis dans une unité de livraison commune.

3. Dispositif selon la revendication 2, **caractérisé en ce que** le support de données fait partie d'un dispositif de commande (17) pour le dispositif de positionnement (4, 20).

4. Dispositif selon la revendication 3, **caractérisé en ce que** le dispositif de commande (17) peut être fixé sur le support (3) et forme, avec celui-ci et le dispositif de positionnement (4), une unité de montage complète.

5. Dispositif selon l'une des revendications précédentes, **caractérisé en ce que** différentes têtes d'équipement peuvent être ajoutées sur le dispositif de positionnement (4, 20) et **en ce que** les têtes d'équipement sont pourvues d'une mémoire pour des données caractéristiques spécifiques à la tête.

6. Dispositif selon l'une des revendications précédentes, **caractérisé en ce que** le support similaire à une plaque est situé au-dessus d'au moins un site d'équipement (7) pour les substrats (6) et **en ce que** le corps d'appui (2) est pourvu, sur les côtés de la zone de déplacement du dispositif de positionnement, d'appuis (8, 10) se dressant vers le haut pour le support (3, 23) et **en ce que** le dispositif de positionnement (4, 20) est situé sur le côté inférieur du support (3, 23).

7. Dispositif selon l'une des revendications précédentes, **caractérisé en ce que** différents dispositifs de positionnement (4, 20) peuvent être fixés sur le support (3, 20).

8. Dispositif selon la revendication 7, **caractérisé en ce que** les dispositifs de positionnement (4, 20) peuvent être fixés dans une configuration différente sur le support (3, 23).

9. Dispositif selon l'une des revendications précédentes, **caractérisé en ce que** différents supports (3, 23) peuvent être fixés sur le corps d'appui (2) pour différents dispositifs de positionnement (4, 20).

10. Dispositif selon la revendication 9, **caractérisé en ce que** le dispositif de positionnement (4, 20) comprend une glissière de guidage longitudinale (12, 21) fixée sur le support (3, 23) et au moins un bras de positionnement (13, 22) transversal monté sur cette dernière de manière à pouvoir se déplacer et sur lequel la tête d'équipement (14) est montée de manière déplaçable.

11. Dispositif selon la revendication 10, **caractérisé en ce que** le site d'équipement (7) est situé sur une voie de transport (5) pour les substrats (6) et **en ce que** des emplacements pour les dispositifs d'alimentation (11) des composants (15) sont prévus sur les côtés de la voie de transport.

12. Dispositif selon la revendication 10 ou 11, **caractérisé en ce que** la glissière de guidage longitudinale (12) s'étend de manière centrale au-dessus de la voie de transport (5) parallèlement à celui-ci et **en ce que** le bras de positionnement (13) avance sur les deux côtés jusqu'au-dessus de positions d'enlèvement (16) des deux dispositifs d'alimentation (11).

13. Dispositif selon la revendication 11, **caractérisé en ce que** la glissière de guidage longitudinale (21) s'étend au-dessus du site d'équipement (7) transversalement à la voie de transport (5) et **en ce que** deux des bras de positionnement (22) mobiles indépendamment l'un de l'autre peuvent se déplacer sur la glissière de guidage longitudinale (21).

14. Dispositif selon l'une des revendications précédentes, **caractérisé en ce que** les points d'appui (24) pour l'appui du support (3, 23) sur le corps d'appui (2) sont formés par des surfaces d'appui horizontales qui sont toutes situées dans un plan.
